# EUROPEAN PATENT SPECIFICATION

(11) **EP 3 174 185 B1**
(45) Date of publication and mention of the grant of the patent: **16.09.2020**
(21) Application number: 16184829.6
(22) Date of filing: 09.04.2013
(51) Int. Cl.: H02M 1/00, H01L 25/16, H01L 23/495

(54) **POWER SUPPLY MODULE AND METHOD FOR PACKAGING POWER SUPPLY MODULE**
STROMVERSORGUNGSMODUL UND VERFAHREN ZUM VERPACKEN DES STROMVERSORGUNGSMODULS
MODULE D'ALIMENTATION ÉLECTRIQUE ET PROCÉDÉ D'EMBALLAGE DE MODULE D'ALIMENTATION ÉLECTRIQUE

(30) Priority: 30.07.2012 CN 201210268316
(43) Date of publication of application: 31.05.2017
(62) Divisional of application: 13824822.4
(73) Proprietor: Huawei Technologies Co., Ltd., Longgang District Shenzhen, Guangdong 518129 (CN)
(72) Inventor: DUAN, Zhihua, Shenzhen, Guangdong 518129 (CN); HOU, Zhaozheng, Shenzhen, Guangdong 518129 (CN)
(74) Representative: Thun, Clemens

(56) References cited:
- EP-A1- 1 091 404
- WO-A2-2008/011459
- CN-A- 102 171 825
- US-A- 5 839 184
- US-A1- 2005 285 262
- US-A1- 2007 074 386

## Description

### TECHNICAL FIELD

Embodiments of the present invention relate to a power supply module and a method for packaging a power supply module.

### BACKGROUND

Main components of a power supply module include a power switch, an integrated circuit (Integrated circuit, IC for short), and passive devices. The passive devices include a magnetic device, a resistor, and a capacitor. The magnetic device may be an inductor. A commonly used power switch is a metal-oxide semiconductor field- effect transistor (MOSFET Metallic Oxide Semiconductor Field Effect Transistor, MOSFET for short) or an insulated gate bipolar transistor (Insulated Gate Bipolar Transistor, IGBT for short), and the IC may be a driver chip, a PWM control chip, or a combination of a driver chip and a PWM control chip. Currently, power supply manufacturers and semiconductor manufacturers, in packaging and integration solutions for power supply modules, mostly use a structure into which a MOSFET, an IC, and passive devices are integrated. A PCB or another lead frame uses a gold wire or copper wire bonding interconnection manner. As a switch, the MOSFET is controlled or driven by the IC to perform pulse width modulation on an input power supply, and after filtering is performed by an inductor and a capacitor, a voltage required by a load is output.

Currently, a magnetic device in a power supply module is generally a surface mount magnetic device or a winding magnetic device including a magnetic core material. The surface mount magnetic device has a small inductance and cannot meet requirements on power density and power supply efficiency, so that reliability of the power supply module deteriorates. An inductance of the winding magnetic device including the magnetic core material is large; however, a winding magnetic device that has been packaged is used in the power supply module, leading to a high risk of welding joint cracking, a high failure probability, and low reliability.
For example, EP 2 482 312 A2 refers to a power supply module and a packaging and integrating method thereof. The power supply module includes a lead frame, a passive element, an integrated circuit IC, and a power switch Metallic Oxide Semiconductor Field Effect Transistor MOSFET. The passive element is soldered onto the lead frame by using the surface mount technology. The IC is a flip chip and is mounted and soldered onto the lead frame.
Further, US 20050285262 refers to a semiconductor device (10), which includes a semiconductor die (20) and an inductor (30, 50) formed with a bonding wire (80) attached to a top surface (21) of the semiconductor die. The bonding wire is extended laterally a distance (L30, L150) greater than its height (H30, H50) to define an insulating core (31, 57). In one embodiment, the inductor is extended beyond an edge (35, 39) of the semiconductor die to reduce loading.
Further, US 5,839,184 refers to a method for creating an inductor in the package for an integrated circuit. The inductor is formed by utilizing one or more of the bond leads as the core of the inductor and by winding a series of coils about the core in connection either with the bond pads of the integrated circuit itself or to other bond leads for connection outside the integrated circuit chip.
Further, WO 2008/011459 A2 refers to an electronic device with one or more semiconductor chips having an inductor assembled on or under the chips. The inductor includes a ferromagnetic body and a wire wrapped around the body to form at least a portion of a loop. The wire ends are connected to the chips. The assembly is attached to a substrate, which may be a leadframe. The device may be encapsulated in molding compound so that the inductor can double as a heat spreader, enhancing the thermal device characteristics.
Further, US 2007/0074386 A1 refers to a method of forming a power module located on a conductive substrate by providing power conversion circuitry. The method of providing the power conversion circuitry includes forming a magnetic device by placing a magnetic core proximate a conductive substrate with a surface thereof facing a conductive substrate, and placing a conductive clip proximate a surface of the magnetic core. The method of forming the magnetic device also includes electrically coupling ends of the conductive clip to the conductive substrate to cooperatively form a winding therewith about the magnetic core. The method of providing the power conversion circuitry also includes providing at least one switch on the conductive substrate. The method of forming the power module also includes depositing an encapsulant about the power conversion circuitry.
In addition, EP 1 091 404 A1 refers to a lead frame for use in packaging a circuit having a discrete component, and a method of manufacture thereof. In one embodiment, the lead frame includes a lead support structure and a plurality of severable leads that are coupled to the lead support structure. The plurality of severable leads extend inward from the lead support structure to predetermined locations corresponding to terminals of the discrete component.

### SUMMARY

Embodiments of the present invention provide a power supply module and a method for packaging a power supply module, so as to lower a failure probability of a magnetic device winding in the power supply module and improve reliability of the power supply module.

According to one aspect, an embodiment of the present invention provides a power supply module, including:
a lead frame, an integrated circuit, passive devices, and two semiconductor bare chips, where
at least one magnetic device in the passive devices is a discrete magnetic device obtained by assembling a magnetic core and an electrical winding; and
one end of the electrical winding is electrically connected to the lead frame, so that the one end of the electrical winding is electrically connected to the integrated circuit and the passive devices except all magnetic devices by means of the lead frame; wherein a source of one of the two semiconductor bare chips is electrically connected to a gate of the other semiconductor bare chip; and the other end of the electrical winding is electrically connected to the source of the one semiconductor bare chip directly, and the other end of the electrical winding is further electrically connected to the gate of the other semiconductor bare chip directly;
wherein the electrical winding is an aluminum strip, the one end of the electrical winding is electrically connected to the lead frame in a bonding manner or an adhering manner, and the other end of the electrical winding is electrically connected to the semiconductor bare chips in a bonding manner or an adhering manner directly.

According to another aspect, an embodiment of the present invention further provides a method for packaging a power supply module, including:
surface-mounting at least one semiconductor bare chip, passive devices except a magnetic device, and an integrated circuit on a lead frame;
surface-mounting, on the lead frame, a discrete magnetic device obtained by assembling a magnetic core and an electrical winding;
electrically connecting a source of one of the two semiconductor bare chips to a gate of the other semiconductor bare chip, and connecting one end of the electrical winding to the lead frame, and electrically connecting the other end of the electrical winding to the source of the one semiconductor bare chip directly, and further electrically connecting the other end of the electrical winding to the gate of the other semiconductor bare chip directly; and
after plastic packaging is performed on the lead frame on which components are surface-mounted, cutting the lead frame to obtain a single power supply module;
wherein the electrical winding is an aluminum strip, the one end of the electrical winding is electrically connected to the lead frame in a bonding manner or an adhering manner, and the other end of the electrical winding is electrically connected to the semiconductor bare chips in a bonding manner or an adhering manner directly.

In the technical solutions of the embodiments of the present invention, at least one magnetic device in a power supply module is a discrete magnetic device obtained by assembling a magnetic core and an electrical winding in a process of packaging the power supply module instead of a packaged magnetic device independently packaged. One end of the electrical winding of the discrete magnetic device is electrically connected to the semiconductor bare chips directly and does not need to be electrically connected to the semiconductor bare chips by means of a lead frame. The magnetic device in the power supply module provided in the embodiments of the present invention is a discrete magnetic device, which reduces mechanical stress of an electrical connection between the magnetic device and the lead frame, improves heat dissipation performance, and lowers a failure probability of the magnetic device. Meanwhile, the one end of the electrical winding of the discrete magnetic device is electrically connected to the semiconductor bare chips directly, which further reduces connection wires between internal devices of the power supply module, lowers impedance, and improves efficiency of the power supply module.

### BRIEF DESCRIPTION OF DRAWINGS

FIG. 1 is a flowchart of a method for packaging a power supply module according to an embodiment of the present invention; and
FIG. 2 is a flowchart of step 32 in FIG. 1.

### DESCRIPTION OF EMBODIMENTS

A power supply module provided in an embodiment of the present invention includes a lead frame, an integrated circuit, passive devices, and two semiconductor bare chips. The semiconductor bare chips may be a MOSFET, or an IGBT, or a combination of an IGBT and a MOSFET. The power supply module provided in the embodiment of the present invention may be mounted on a PCB motherboard by means of the lead frame.

At least one magnetic device in the passive devices is a discrete magnetic device including a magnetic core and an electrical winding. The power supply module provided in the embodiment of the present invention has at least one discrete magnetic device, and the discrete magnetic device is a magnetic device obtained by assembling a magnetic core and an electrical winding in a process of packaging the power supply module, is not exteriorly packaged, and is not an independently packaged magnetic device. A material of the electrical winding is aluminum and may be of any proper width and thickness.

One end of the electrical winding of the discrete magnetic device is electrically connected to the lead frame, so that the one end of the electrical winding is electrically connected to the integrated circuit and the passive devices except all magnetic devices by means of the lead frame. The other end of the electrical winding of the discrete magnetic device is electrically connected to the semiconductor bare chips directly and does not need to be electrically connected to the semiconductor bare chips by means of the lead frame.

The electrical winding is electrically connected to the lead frame and the semiconductor bare chips in a bonding manner, or an adhering manner with a conductive adhesive. The electrical winding is an aluminum strip. The one end of the electrical winding is electrically connected to the lead frame in a bonding manner or an adhering manner, and the other end of the electrical winding is electrically connected to the semiconductor bare chips directly in a bonding manner or an adhering manner. Electrical connection is performed in a bonding or adhering manner, which can reduce connection wires between internal devices of the power supply module, reduce parasitic parameters, lower losses, and improve power supply efficiency.

The integrated circuit is connected to the semiconductor bare chips and the passive devices by means of the lead frame.

Further, the power supply module includes two semiconductor bare chips, and a source of one semiconductor bare chip is electrically connected to a gate of the other semiconductor bare chip; and the other end of the electrical winding is electrically connected to the source of the one semiconductor bare chip directly, and the other end of the electrical winding is further electrically connected to the gate of the other semiconductor bare chip directly.

In the power supply module provided in this embodiment, at least one magnetic device is a discrete magnetic device obtained by assembling a magnetic core and an electrical winding in a process of packaging the power supply module instead of a packaged magnetic device independently packaged. One end of the electrical winding of the discrete magnetic device is electrically connected to the semiconductor bare chips directly and does not need to be electrically connected to the semiconductor bare chips by means of a lead frame. The magnetic device in the power supply module provided in the embodiment of the present invention is a discrete magnetic device, which reduces mechanical stress of an electrical connection between the magnetic device and the lead frame, improves heat dissipation performance, and lowers a failure probability of the magnetic device. Meanwhile, the one end of the electrical winding of the discrete magnetic device is electrically connected to the semiconductor bare chips directly, which further reduces connection wires between internal devices of the power supply module, lowers impedance, and improves efficiency of the power supply module.

In an embodiment of the present invention, a power supply module is provided. The power supply module provided in this embodiment includes a magnetic device, and the magnetic device is a discrete magnetic device obtained by assembling two half magnetic cores and an electrical winding. A magnetic core of the discrete magnetic device includes two half magnetic cores disposed in a coupling manner, and the electrical winding is disposed in space between the two coupled half magnetic cores. Preferably, a protruding part such as a protruding cylinder is disposed in a center of a surface of each half magnetic core, and the two half magnetic cores are disposed in a coupling manner by means of the central protruding parts.

The discrete magnetic device in this embodiment includes a half magnetic core, a half magnetic core, and an electrical winding. A protruding part is disposed in a center of each of the half magnetic core and the half magnetic core, and the half magnetic core and the half magnetic core are disposed in a coupling manner by means of the central protruding parts. The electrical winding is disposed in space between the half magnetic core and the half magnetic core that are coupled together. Therefore, the electrical winding is wrapped by the half magnetic core and the half magnetic core. One end of the electrical winding is electrically connected to a lead frame, that is, the one end of the electrical winding is electrically connected to an integrated circuit 5 and passive devices except the magnetic device by means of the lead frame.

Tthe power supply module includes two cascaded semiconductor bare chips, and a source of the one semiconductor bare chip is electrically connected to a gate of the other semiconductor bare chip. The other end of the electrical winding 23 is electrically connected to the one semiconductor bare chip and the other semiconductor bare chip directly, that is, the other end of the electrical winding is electrically connected to the source of the one semiconductor bare chip directly, and is further electrically connected to the gate of the other semiconductor bare chip directly. The semiconductor bare chips are further electrically connected to the integrated circuit by means of the lead frame.

The discrete magnetic device in this embodiment is not manufactured independently, but obtained by assembly in a module packaging process. A half magnetic core with a central protruding part is first mounted on the lead frame, and a surface, of the half magnetic core, without a protruding part is disposed on the lead frame, and then the electrical winding is laid on the half magnetic core. Then, the one end of the electrical winding is connected to the lead frame, and the other end is electrically connected to the semiconductor bare chips directly. Then, a central protruding part of the other half magnetic core is coupled to the protruding part of the half magnetic core that has been mounted, to close a magnetic circuit of the electrical winding.

In another embodiment of the present invention another power supply module is provided. In the power supply module provided in this embodiment, a discrete magnetic device is obtained by assembling a magnetic core and an electrical winding, and the electrical winding is wound around an exterior of the magnetic core.

An electrical winding is wound around an exterior of a magnetic core, and the magnetic core wound with the electrical winding forms a discrete magnetic device by assembly. One end of the electrical winding is electrically connected to a lead frame, that is, the one end of the electrical winding is electrically connected to an integrated circuit and passive devices except the magnetic device by means of the lead frame.

The power supply module includes two cascaded semiconductor bare chips, and a source of the one semiconductor bare chip is electrically connected to a gate of the other semiconductor bare chip. The other end of the electrical winding is electrically connected to the one semiconductor bare chip and the other semiconductor bare chip directly, that is, the other end of the electrical winding is electrically connected to the source of the one semiconductor bare chip directly, and is further electrically connected to the gate of the other semiconductor bare chip directly. The other end of the electrical winding is connected to a top portion of the semiconductor bare chips, and a bottom portion of the semiconductor bare chips is connected to the lead frame by using soldering tin, and is connected to an electrical winding at a bottom portion of the magnetic core.

The discrete magnetic device in this embodiment is not manufactured independently, but obtained by assembly in a module packaging process. A magnetic core of which an exterior is wound with the electrical winding is first mounted on the lead frame, and then one exposed end of the electrical winding is connected to the lead frame, and the other exposed end is electrically connected to the semiconductor bare chips directly.

In the embodiments above, the electrical winding is a metal strip-shaped wire with one or more turns. When the electrical winding has multiple turns, the turns are connected to each other in series or in parallel, and one end of each turn is electrically connected to the lead frame in a mechanical press-fit manner.

In the embodiments above, the electrical winding is an aluminum strip. The one end of the electrical winding is electrically connected to the lead frame in a bonding manner or an adhering manner, and the other end of the electrical winding is electrically connected to the semiconductor bare chips in a bonding manner or an adhering manner directly.

Preferably, in the embodiments above, the semiconductor bare chips are vertical semiconductor devices.

In the foregoing embodiments, a lead frame may be obtained by using a stamping technique known in the art, or may be a predetermined graph obtained by using an etched conductive plate, or may be obtained with reference to the stamping technique and an etching technique. Therefore, a structure of the lead frame in the embodiments may be a continuous or discontinuous metal structure. The structure of the lead frame includes any proper material, may be of any proper form and thickness, and further includes a metal coating layer on the lead frame, such as a silver coating layer, a nickel-gold coating layer, or a nickel-palladium-gold coating layer. Exemplarily, a body material of the lead frame includes copper, aluminum and aluminum alloy, ferronickel, and the like. The lead frame is initially one of many units of a lead frame array that are connected together by using a tie rod. In a technique for packaging a manufactured semiconductor die, the lead frame array may be cut or punched so that packaging is performed separately. In addition, the structure of the lead frame may have multiple die pad areas (DAP) in which a die attach pad Die Attach Pad may be formed, and a lead may be coplanar with or not coplanar with a surface of a die attach pad DAP.

In the foregoing embodiments, a module packaging material used for packaging the power supply module may include a proper material, such as a multifunctional cross-linked epoxy resin composite material. The module packaging material is softened from a fixed material cake form at a high temperature to a colloidal state in which solids and liquids coexist, transferred and injected into a mould to shape with a lead frame placed in the mould, and solidified and shaped after a crosslinking reaction.

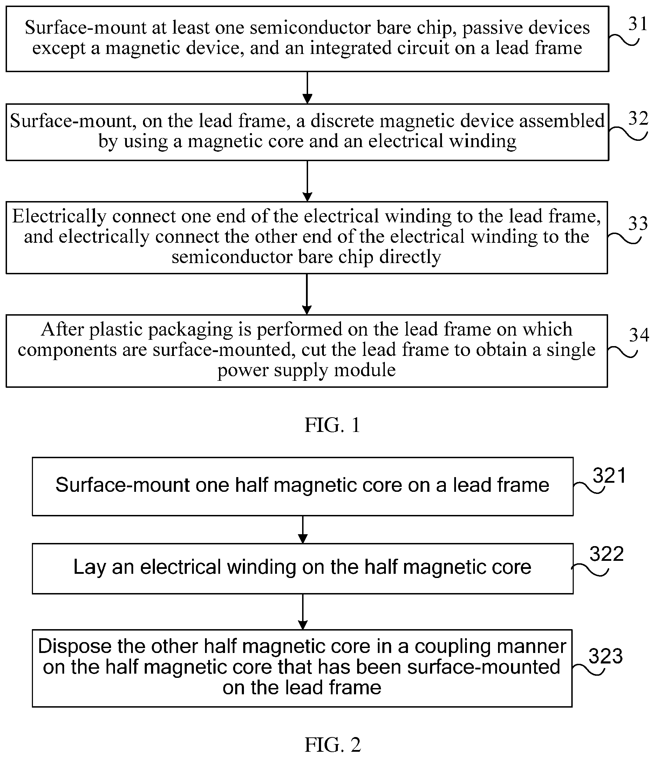

FIG. 1 is a flowchart of a method for packaging a power supply module according to an embodiment of the present invention. The packaging method provided in this embodiment includes:
Step 31: Surface-mount two semiconductor bare chips, passive devices except a magnetic device, and an integrated circuit on a lead frame.

Step 32: Surface-mount, on the lead frame, a discrete magnetic device obtained by assembling a magnetic core and an electrical winding.

The discrete magnetic device is a magnetic device obtained by assembling the magnetic core and the electrical winding in a process of packaging the power supply module, is not exteriorly packaged, and is not an independently packaged magnetic device. A material of the foregoing electrical winding is aluminum, and may be of any proper width and thickness.

Step 33: Electrically connect one end of the electrical winding to the lead frame, and electrically connect the other end of the electrical winding to the semiconductor bare chips directly.

One end of the electrical winding of the discrete magnetic device is electrically connected to the lead frame, so that the one end of the electrical winding is electrically connected to the integrated circuit and the passive devices except the magnetic device by means of the lead frame. The other end of the electrical winding of the discrete magnetic device is electrically connected to the semiconductor bare chips directly and does not need to be electrically connected to the semiconductor bare chips by means of the lead frame.

The electrical winding is electrically connected to the lead frame and the semiconductor bare chips in a bonding manner, or an adhering manner with a conductive adhesive. The electrical winding is an aluminum strip. The one end of the electrical winding is electrically connected to the lead frame in a bonding manner or an adhering manner, and the other end of the electrical winding is electrically connected to the semiconductor bare chips directly in a bonding manner or an adhering manner. Electrical connection is performed in a bonding or adhering manner, which can reduce connection wires between internal devices of the power supply module, reduce parasitic parameters, lower losses, and improve power supply efficiency.

Step 34: After plastic packaging is performed on the lead frame on which components are surface-mounted, cut the lead frame to obtain a single power supply module.

The electrical winding is a metal strip-shaped wire with one or more turns. When the electrical winding has multiple turns, the turns are connected to each other in series or in parallel, and one end of each turn is electrically connected to the lead frame in a mechanical press-fit manner.

Preferably, the semiconductor bare chips are vertical semiconductor devices.

According to the packaging method provided in this embodiment, a discrete magnetic device obtained by assembling a magnetic core and an electrical winding is surface-mounted on a lead frame instead of surface-mounting an independently packaged magnetic device on the lead frame. One end of the electrical winding of the discrete magnetic device is electrically connected to the semiconductor bare chips directly rather than electrically connected to the semiconductor bare chips by means of the lead frame. The magnetic device in the power supply module provided in the embodiment of the present invention is a discrete magnetic device, which reduces mechanical stress of an electrical connection between the magnetic device and the lead frame and improves heat dissipation performance. Meanwhile, the one end of the electrical winding of the discrete magnetic device is electrically connected to the semiconductor bare chips directly, which further reduces connection wires between internal devices of the power supply module, lowers impedance, and improves efficiency of the power supply module.

FIG. 2 is a flowchart of step 32 in FIG. 1. In this embodiment, two half magnetic cores and the electrical winding are used to assemble the discrete magnetic device, and the packaging method provided in this embodiment is a method for packaging the power supply module provided above. As shown in FIG. 2, step 32 includes:
Step 321: Surface-mount one half magnetic core on the lead frame.

Step 322: Lay the electrical winding on the half magnetic core.

Step 323: Dispose the other half magnetic core in a coupling manner on the half magnetic core that has been surface-mounted on the lead frame.

A specific packaging process is as follows: preparing the lead frame, coating a solder paste on the lead frame, surface-mounting the semiconductor bare chips and the passive devices except the magnetic device on the lead frame, and performing washing; then, performing, on the lead frame, dispensing for mounting the integrated circuit and the half magnetic core, and surface-mounting the integrated circuit and the half magnetic core with a central protruding part on the lead frame, where the central protruding part of the half magnetic core faces upwards; filling the bottom portions of the integrated circuit and the half magnetic core with a filling adhesive and solidifying the bottom portions; laying the electrical winding on the half magnetic core, and respectively connecting the two ends of the electrical winding to the lead frame and the semiconductor bare chips in a bonding manner; connecting the integrated circuit and the semiconductor bare chips in a bonding manner; performing dispensing on the central protruding part of the half magnetic core that has been surface-mounted on the lead frame, and surface-mounting a central protruding part of the other half magnetic core on the central protruding part that has been surface-mounted on the lead frame, so that the two half magnetic cores are disposed in a coupling manner; and after plastic packaging is performed on the lead frame on which components are surface-mounted, cutting the lead frame to obtain a single power supply module.

In addition, the present invention may also use a magnetic core of which an exterior is wound with the electrical winding to assemble the discrete magnetic device. In this case, step 32 may be specifically surface-mounting, on the lead frame, the magnetic core of which the exterior is wound with the electrical winding. A specific packaging process is as follows: preparing the lead frame, coating a solder paste on the lead frame, surface-mounting the semiconductor bare chips and the passive devices except the magnetic device on the lead frame, and performing washing; then, performing, on the lead frame, dispensing for mounting the integrated circuit and the magnetic core, and surface-mounting the integrated circuit and the magnetic core of which the exterior is wound with the electrical winding on the lead frame; respectively connecting the two ends of the electrical winding to the lead frame and the semiconductor bare chips in a bonding manner; connecting the integrated circuit and the semiconductor bare chips in a bonding manner; and after plastic packaging is performed on the lead frame on which components are surface-mounted, cutting the lead frame to obtain a single power supply module. The foregoing packaging method may be a method for packaging the power supply module provided above.

According to the packaging method provided in the embodiments, a discrete magnetic device obtained by assembling a magnetic core and an electrical winding is surface-mounted on a lead frame instead of surface-mounting an independently packaged magnetic device on the lead frame. One end of the electrical winding of the discrete magnetic device is electrically connected to the semiconductor bare chips directly and does not need to be electrically connected to the semiconductor bare chips by means of the lead frame. The magnetic device in a power supply module provided in the embodiments of the present invention is a discrete magnetic device, which reduces mechanical stress of an electrical connection between the magnetic device and the lead frame and improves heat dissipation performance. Meanwhile, the one end of the electrical winding of the discrete magnetic device is electrically connected to the semiconductor bare chips directly, which further reduces connection wires between internal devices of the power supply module, lowers impedance, and improves efficiency of the power supply module.

## Claims

1. A power supply module, comprising a lead frame, an integrated circuit, passive devices, and two semiconductor bare chips, wherein:
at least one magnetic device in the passive devices is a discrete magnetic device obtained by assembling a magnetic core and an electrical winding; and
one end of the electrical winding is electrically connected to the lead frame, so that the one end of the electrical winding is electrically connected to the integrated circuit and the passive devices except all magnetic devices by means of the lead frame;
**characterized in that**
a source of one of the two semiconductor bare chips is electrically connected to a gate of the other semiconductor bare chip; and the other end of the electrical winding is electrically connected to the source of the one semiconductor bare chip directly, and the other end of the electrical winding is further electrically connected to the gate of the other semiconductor bare chip directly.
wherein the electrical winding is an aluminum strip, the one end of the electrical winding is electrically connected to the lead frame in a bonding manner or an adhering manner, and the other end of the electrical winding is electrically connected to the semiconductor bare chip in a bonding manner or an adhering manner directly.

2. The power supply module according to claim 1, wherein the magnetic core comprises two half magnetic cores disposed in a coupling manner, and the electrical winding is disposed in space between the two coupled half magnetic cores.

3. The power supply module according to claim 1, wherein the electrical winding is wound around an exterior of the magnetic core.

4. The power supply module according to any one of claims 1 to 3, wherein the electrical winding has one or more turns.

5. The power supply module according to any one of claims 1 to 3, wherein when the electrical winding has multiple turns, the turns are connected to each other in series or in parallel.

6. The power supply module according to any one of claims 1 to 5, wherein the semiconductor bare chips are vertical semiconductor devices.

7. A method for packaging a power supply module, comprising:
surface-mounting (step 31), two semiconductor bare chips, passive devices except a magnetic device, and an integrated circuit on a lead frame (step 31);
surface-mounting (step 32), on the lead frame, a discrete magnetic device obtained by assembling a magnetic core and an electrical winding;
electrically connecting (step 33) a source of one of the two semiconductor bare chips to a gate of the other semiconductor bare chip, and electrically connecting one end of the electrical winding to the lead frame, and electrically connecting the other end of the electrical winding to the source of the one semiconductor bare chip directly, and further electrically connecting the other end of the electrical winding to the gate of the other semiconductor bare chip directly; and
after plastic packaging is performed on the lead frame on which components are surface-mounted, cutting (step 34), the lead frame to obtain a single power supply module;
wherein the electrical winding is an aluminum strip, the one end of the electrical winding is electrically connected to the lead frame in a bonding manner or an adhering manner, and the other end of the electrical winding is electrically connected to the semiconductor bare chip in a bonding manner or an adhering manner directly.

8. The method according to claim 7, wherein the surface-mounting, on the lead frame, a discrete magnetic device obtained by assembling a magnetic core and an electrical winding comprises:
surface-mounting (step 321), a half magnetic core on the lead frame;
laying, (step 322) the electrical winding on the half magnetic core; and
disposing, (step 323) another half magnetic core in a coupling manner on the half magnetic core that has been surface-mounted on the lead frame.

9. The method according to claim 7, wherein the surface-mounting, on the lead frame, a discrete magnetic device obtained by assembling a magnetic core and an electrical winding comprises:
surface-mounting, on the lead frame, a magnetic core of which an exterior is wound with the electrical winding.

10. The method according to any one of claims 7 to 9, wherein when the electrical winding has multiple turns, the turns are connected to each other in series or in parallel.

## Patentansprüche

1. Stromversorgungsmodul, umfassend eine Leiterplatine, eine integrierte Schaltung, passive Bauelemente und zwei nackte Halbleiterchips, wobei:
mindestens ein magnetisches Bauelement in den passiven Bauelementen ein diskretes magnetisches Bauelement ist, das durch Montieren eines magnetischen Kerns und einer elektrischen Windung erhalten wird; und
ein Ende der elektrischen Windung elektrisch mit der Leiterplatine verbunden ist, so dass das eine Ende der elektrischen Windung mittels der Leiterplatine elektrisch mit der integrierten Schaltung und den passiven Bauelementen mit Ausnahme aller magnetischen Bauelemente verbunden ist;
**dadurch gekennzeichnet, dass**
eine Source von einem der beiden nackten Halbleiterchips elektrisch mit einem Gate des anderen nackten Halbleiterchips verbunden ist; und das andere Ende der elektrischen Windung direkt elektrisch mit der Source des einen nackten Halbleiterchips verbunden ist, und das andere Ende der elektrischen Windung ferner direkt elektrisch mit dem Gate des anderen nackten Halbleiterchips verbunden ist,
wobei die elektrische Windung ein Aluminiumstreifen ist, das eine Ende der elektrischen Windung in bindender Weise oder haftender Weise elektrisch mit der Leiterplatine verbunden ist, und das andere Ende der elektrischen Windung direkt in bindender Weise oder in haftender Weise elektrisch mit dem nackten Halbleiterchip verbunden ist.

2. Stromversorgungsmodul nach Anspruch 1, wobei der magnetische Kern zwei halbe magnetische Kerne umfasst, die in gekoppelter Weise angeordnet sind, und wobei die elektrische Windung im Raum zwischen den beiden gekoppelten halben magnetischen Kernen angeordnet ist.

3. Stromversorgungsmodul nach Anspruch 1, wobei die elektrische Windung um einen Außenbereich des magnetischen Kerns herum gewickelt ist.

4. Stromversorgungsmodul nach einem der Ansprüche 1 bis 3, wobei die elektrische Windung eine oder mehrere Wicklungen aufweist.

5. Stromversorgungsmodul nach einem der Ansprüche 1 bis 3, wobei die Wicklungen, wenn die elektrische Windung mehrere Wicklungen aufweist, miteinander in Reihe oder parallel verbunden sind.

6. Stromversorgungsmodul nach einem der Ansprüche 1 bis 5, wobei die nackten Halbleiterchips vertikale Halbleiterbauelemente sind.

7. Verfahren zum Kapseln eines Stromversorgungsmoduls, umfassend:
Oberflächenmontieren (Schritt 31) von zwei nackten Halbleiterchips, passiven Bauelementen mit Ausnahme eines magnetischen Bauelements sowie einer integrierten Schaltung auf einer Leiterplatine (Schritt 31);
Oberflächenmontieren (Schritt 32) eines diskreten magnetischen Bauelements, welches durch Montieren eines magnetischen Kerns und einer elektrischen Windung erhalten wird, auf der Leiterplatine;
elektrisches Verbinden (Schritt 33) einer Source von einem der beiden nackten Halbleiterchips mit einem Gate des anderen nackten Halbleiterchips, und elektrisches Verbinden von einem Ende der elektrischen Windung mit der Leiterplatine, und elektrisches Verbinden des anderen Endes der elektrischen Windung direkt mit der Source des einen nackten Halbleiterchips, und ferner elektrisches Verbinden des anderen Endes der elektrischen Windung direkt mit dem Gate des anderen nackten Halbleiterchips; und
nachdem die Kunststoffkapselung auf der Leiterplatte durchgeführt worden ist, auf der Komponenten oberflächenmontiert worden sind, Schneiden (Schritt 34) der Leiterplatine, um ein einzelnes Stromversorgungsmodul zu erhalten;
wobei die elektrische Windung ein Aluminiumstreifen ist, das eine Ende der elektrischen Windung in bindender Weise oder haftender Weise elektrisch mit der Leiterplatine verbunden ist, und das andere Ende der elektrischen Windung direkt in bindender Weise oder in haftender Weise elektrisch mit dem nackten Halbleiterchip verbunden ist.

8. Verfahren nach Anspruch 7, wobei das Oberflächenmontieren eines diskreten magnetischen Bauelements, welches durch Montieren eines magnetischen Kerns und einer elektrischen Windung erhalten wird, auf der Leiterplatine umfasst:
Oberflächenmontieren (Schritt 321) eines halben magnetischen Kerns auf der Leiterplatine;
Verlegen (Schritt 322) der elektrischen Windung auf dem halben magnetischen Kern; und
Anordnen (Schritt 323) eines weiteren halben magnetischen Kerns in koppelnder Weise auf dem halben magnetischen Kern, der auf der Leiterplatine oberflächenmontiert worden ist.

9. Verfahren nach Anspruch 7, wobei das Oberflächenmontieren eines diskreten magnetischen Bauelements, welches durch Montieren eines magnetischen Kerns und einer elektrischen Windung erhalten wird, auf der Leiterplatine umfasst:
Oberflächenmontieren eines magnetischen Kerns, dessen Außenbereich mit der elektrischen Windung umwickelt ist, auf der Leiterplatine.

10. Verfahren nach einem der Ansprüche 7 bis 9, wobei die Wicklungen, wenn die elektrische Windung mehrere Wicklungen aufweist, miteinander in Reihe oder parallel verbunden sind.

## Revendications

1. Module d'alimentation, comprenant une grille de connexion, un circuit intégré, des dispositifs passifs et deux puces nues semiconductrices, et dans lequel :
au moins un dispositif magnétique parmi les dispositifs passifs est un dispositif magnétique discret obtenu en assemblant un noyau magnétique et un enroulement électrique ; et
une extrémité de l'enroulement électrique est connectée électriquement à la grille de connexion, de sorte que ladite extrémité de l'enroulement électrique soit connectée électriquement au circuit intégré et aux dispositifs passifs à l'exception de tous les dispositifs magnétiques, au moyen de la grille de connexion ;
**caractérisé en ce que** :
une source d'une des deux puces nues semiconductrices est connectée électriquement à une grille de l'autre puce nue semiconductrice ; et l'autre extrémité de l'enroulement électrique est directement connectée électriquement à la source de ladite puce nue semiconductrice, et l'autre extrémité de l'enroulement électrique est en outre directement connectée électriquement à la grille de l'autre puce nue semiconductrice,
l'enroulement électrique étant une bande d'aluminium, ladite extrémité de l'enroulement électrique étant connectée électriquement à la grille de connexion par soudure ou par adhésion, et l'autre extrémité de l'enroulement électrique étant connectée électriquement à la puce nue semiconductrice par soudure ou par adhésion.

2. Module d'alimentation selon la revendication 1, dans lequel le noyau magnétique comprend deux demi-noyaux magnétiques disposés en accouplement et l'enroulement électrique est disposé dans un espace entre les deux demi-noyaux magnétiques accouplés.

3. Module d'alimentation selon la revendication 1, dans lequel l'enroulement électrique est enroulé autour d'un extérieur du noyau magnétique.

4. Module d'alimentation selon l'une quelconque des revendications 1 à 3, dans lequel l'enroulement électrique comporte une ou plusieurs spires.

5. Module d'alimentation selon l'une quelconque des revendications 1 à 3, dans lequel l'enroulement électrique comporte plusieurs spires, les spires étant connectées les unes aux autres en série ou en parallèle.

6. Module d'alimentation selon l'une quelconque des revendications 1 à 5, dans lequel les puces nues semiconductrices sont des dispositifs semiconducteurs verticaux.

7. Procédé de conditionnement d'un module d'alimentation, comprenant les étapes consistant à :
monter en surface (étape 31), sur une grille de connexion, deux puces nues semiconductrices, des dispositifs passifs à l'exception d'un dispositif magnétique et un circuit intégré (étape 31) ;
monter en surface (étape 32), sur la grille de connexion, un dispositif magnétique discret obtenu en assemblant un noyau magnétique et un enroulement électrique ;
connecter électriquement (étape 33) une source d'une des deux puces nues semiconductrices à une grille de l'autre puce nue semiconductrice, et connecter électriquement une extrémité de l'enroulement électrique à la grille de connexion, et
directement connecter électriquement l'autre extrémité de l'enroulement électrique à la source de ladite puce nue semiconductrice, et en outre directement connecter électriquement l'autre extrémité de l'enroulement électrique à la grille de l'autre puce nue semiconductrice ; et
après la réalisation d'un conditionnement plastique sur la grille de connexion où les composants sont montés en surface, découper (étape 34) la grille de connexion afin d'obtenir un unique module d'alimentation ;
l'enroulement électrique étant une bande d'aluminium, ladite extrémité de l'enroulement électrique étant connectée électriquement à la grille de connexion par soudure ou par adhésion, et l'autre extrémité de l'enroulement électrique étant connectée électriquement à la puce nue semiconductrice par soudure ou par adhésion.

8. Procédé selon la revendication 7, dans lequel le montage en surface, sur la grille de connexion, d'un dispositif magnétique discret obtenu en assemblant un noyau magnétique et un enroulement électrique comprend les étapes consistant à :
monter en surface (étape 321) un demi-noyau magnétique sur la grille de connexion ;
déposer (étape 322) l'enroulement électrique sur le demi-noyau magnétique ; et
disposer (étape 323) un autre demi-noyau magnétique en accouplement sur le demi-noyau magnétique qui a été monté en surface sur la grille de connexion.

9. Procédé selon la revendication 7, dans lequel le montage en surface, sur la grille de connexion, d'un dispositif magnétique discret obtenu en assemblant un noyau magnétique et un enroulement électrique comprend l'étape consistant à :
monter en surface, sur la grille de connexion, un noyau magnétique, autour d'un extérieur duquel l'enroulement électrique est enroulé.

10. Procédé selon l'une quelconque des revendications 7 à 9, dans lequel lorsque l'enroulement électrique comporte plusieurs spires, les spires sont connectées les unes aux autres en série ou en parallèle.
